# EUROPEAN PATENT APPLICATION

(11) **EP 4 614 162 A1**
(43) Date of publication of application: **10.09.2025**
(21) Application number: 24161668.9
(22) Date of filing: 06.03.2024
(51) Int. Cl.: G01R 15/06

(54) **CAPACITIVE VOLTAGE SENSOR ARRANGEMENT HAVING A TUNING CIRCUIT AND VOLTAGE SENSOR SYSTEM**

(71) Applicant: TE Connectivity Solutions GmbH, 8200 Schaffhausen (CH); Kries-Energietechnik GmbH & Co. KG, 71334 Waiblingen (DE)
(72) Inventor: Winter, Axel, 8200 Schaffhausen (CH); Greiner, Ulrich, 71344 Waiblingen (DE)
(74) Representative: Grünecker Patent- und Rechtsanwälte PartG mbB

(57) **Abstract**

The present disclosure relates to a capacitive voltage sensor arrangement for an electric energy distribution network. The capacitive voltage sensor arrangement comprises a first input terminal, a second input terminal, a first sensor output terminal and a second sensor output terminal. Further, the capacitive voltage sensor arrangement comprises a capacitive voltage divider, which comprises a primary capacitor arranged between the first input terminal and a first node and a secondary capacitor arranged between the first node and the second input terminal and electrically connected in series to the primary capacitor. The voltage sensor arrangement further comprises a tuning circuit arranged between the first node, a second node, a third node, and a fourth node. The second node is connected with the first sensor output terminal, the third node is connected with the second input terminal, and the fourth node is connected with the second sensor output terminal. Further, the tuning circuit comprises only one or more passive components.

## Description

The present disclosure relates to a capacitive voltage sensor arrangement for an electric energy distribution network having a tuning circuit and to a voltage sensor system.

In large energy distribution networks operating at a high voltage, this high voltage must be transformed to a medium or a low voltage level in order to bring the voltage into a measurable range. Previously, large voltage transformers have been used for such a transformation. The transformers enabled to provide a high power on the transformed, the secondary, side. However, transformers come with the drawback of high costs and a huge size of the overall system.

In recent years, the use of voltage transformers has continued to decline and voltage transformers have been replaced by voltage dividers. Further, the request to get a more detailed insight into distribution networks has become stronger lately. Since the distribution networks are getting more and more complex, the number of voltage measurement systems in the networks that are required and need to be realized increased. Voltage dividers provide an easier and cost efficient solution to transform the voltage into a measurable range. The voltage dividers can be incorporated into voltage sensors which are often available in the form of a plug sensor, bushing, post insulator or a separable connector. The most common types of voltage dividers are resistance voltage dividers and capacitive voltage dividers. These sensors provide an accurate voltage measurement over a wide voltage range. To perform the measurement in the system, the sensors are connected to a measurement device, an intelligent electronic device (IED), which is included into a switching station as part of the energy distribution network.

In theory, the measurement of the transformed voltage at the output of the voltage sensor only depends on the dividing factor of the voltage divider. In real applications, however, the components of the measurement influence the measurement results. Reasons therefor can be the cable that is used to connect the sensor to the measurement device or the measurement device itself. The components influence the signal parameters of the to-be-measured signal such that the transformed low or medium voltage signal is no longer a perfect representation of the original high voltage signal.

The influence on the signal parameters causes a phase shift in the measured signal, which then causes a deviation or rather an error between the ideal amplitude and phase of the signal and the actually measured amplitude and phase of the signal. The limits for such a deviation or error that occurs when using capacitive voltage dividers are defined in an international standard.

The international standard defines the maximum allowable error of voltage dividers and thus defines the required accuracy of the voltage dividers. For example, the international standard IEC 61869-1/6/11 (DIN EN 61869-6:2017-06; DIN EN 61869-1:2010-04; DIN EN 61869-11:2019-01) defines the requirements on the accuracy of so called low-power passive voltage transformers (LVPT). A LVPT in this context relates to voltage dividers in general. The requirements consider different parameters such as magnitude of the voltage, frequency and temperature. Depending on these parameters different values for the maximum allowable error are defined.

To meet the strict requirements with a capacitive voltage divider, the primary capacitance of the primary capacitance is typically chosen very high. A high capacitance, however, has the drawback that the size of the primary capacitor becomes very large. This is due to the fact that the achievable permittivity of a capacitor dielectric and the distance between the electrodes of the capacitor is limited. A large primary capacitor again affects the total size of the voltage sensor. Manufacturing and handling these large sensors becomes inconvenient and difficult to realize.

To overcome the mentioned problem, correction circuits have been used, which aim to correct the amplitude and phase error of the measured signal to be within the defined tolerances. For both parameters, amplitude and phase, a respective calibration or correction factor is measured, and then is fed into the system to correct the signal. Since the calibration factors are specific for every sensor and measurement setup, the correction measurement must take place for every sensor individually while setting up the system. This causes a huge installation effort for the workers and is time consuming for large switching stations that comprise a large number of voltage sensors.

It is therefore an object of the present disclosure to provide an improved voltage sensor arrangement and corresponding voltage sensor system that enables a voltage measurement within the defined tolerances and overcomes the drawbacks of the existing solutions.

This problem is solved by the subject-matter of the independent claims. Advantageous examples of the present disclosure are the subject-matter of the dependent claims.

The present disclosure is based on the idea that a tuning circuit is provided together with a capacitive voltage divider to provide an easy plug-and-play solution in a voltage measurement setup.

In particular, the present disclosure relates to a capacitive voltage sensor arrangement for an electric energy distribution network. The capacitive voltage sensor arrangement comprises a first input terminal, a second input terminal, a first sensor output terminal and a second sensor output terminal. Further, the capacitive voltage sensor arrangement comprises a capacitive voltage divider, which comprises a primary capacitor arranged between the first input terminal and a first node, and a secondary capacitor arranged between the first node and the second input terminal and electrically connected in series to the primary capacitor. Further, the capacitive voltage sensor arrangement comprises a tuning circuit arranged between the first node, a second node, a third node, and a fourth node. The second node is connected with the first sensor output terminal, the third node is connected with the second input terminal, and the fourth node is connected with the second sensor output terminal. Further, the tuning circuit comprises only one or more passive components.

The capacitive voltage sensor arrangement advantageously allows to adjust the signal characteristics in order to meet the defined requirements of the voltage measurement. In particular, the tuning circuit advantageously influences the transformation ratio of the capacitive voltage divider such that the accuracy requirements on the phase and amplitude error can be met for lower values of the primary capacitor. This is advantageously achieved by the tuning circuit modifying the capacitance of the secondary capacitor. Thereby, advantageously the tuning circuit comprises only one or more passive components. This means that in the tuning circuit according to the present disclosure no active components are required. This not only eases the circuit design and reduces the complexity, but also is more cost-efficient.

According to an advantageous further development of the present disclosure, the tuning circuit of the capacitive voltage sensor comprises a first resistor arranged between the first node and the second node and has the third node of the tuning circuit directly connected with the fourth node.

This advantageous embodiment of the tuning circuit comprises only at least one resistor and still enables to influence the signal characteristics to meet the accuracy requirements of the voltage measurement.

According to an advantageous further development of the present disclosure, the tuning circuit further comprises a first capacitor arranged in parallel to the first resistor between the first node and the second node and the tuning circuit comprises a second capacitor arranged between the second node and the third node. In an advantageous example of the present invention, the second capacitor denotes the input capacitance of a measurement device that is connected to the tuning circuit and that has a preferred value of around 50 pF.

This further embodiment comprises further passive components and advantageously enables to meet the accuracy requirements for a larger range of frequencies, in particular, the accuracy requirements can be met for large frequencies.

According to an advantageous further development of the present disclosure, the tuning circuit comprises an inductor arranged between the first node and the second node and has the third node of the tuning circuit directly connected with the fourth node.

Advantageously, the tuning circuit according to the present disclosure may also comprise at least one inductor that leads to the same advantageous effects as described with respect to the previous embodiments of the tuning circuit. This shows the adaptability and flexibility of the present solution.

According to an advantageous further development of the present disclosure, the primary capacitor is formed by an electrode arrangement and a dielectric material or is formed by at least one discrete capacitor. Advantageously, the secondary capacitor is formed by an electrode arrangement and a dielectric material or is formed by at least one discrete capacitor.

According to an advantageous further development of the present disclosure, the primary capacitor comprises a capacitance of 10 pF - 30 pF. Advantageously, the secondary capacitor comprises a capacitance of 30 nF - 300 nF.

According to an advantageous further development of the present disclosure, the first resistor comprises a resistance of 500 kΩ - 2 MΩ. Preferably, the first capacitor comprises a capacitance of 1 pF - 50 pF and/or the second capacitor comprises a capacitance of 1 pF - 500 pF.

According to an advantageous further development of the present disclosure, the inductor comprises an inductance of 0.1 H - 5 H.

The choice of the values of the capacitors, the inductors and the resistors of the tuning circuit and of the capacitive voltage divider of course depends on the application. The given values solely show that the idea and concept is applicable to various setups and applications and not restricted to a certain type of voltage measurement setup. Depending on the used capacitive voltage divider, the values of the components of the tuning circuit can be adjusted such that the positive effects of the tuning circuit also occur.

According to an advantageous further development of the present disclosure, the second input terminal is connected to ground.

The present disclosure further relates to a voltage sensor system comprising a first measurement output terminal, a second measurement output terminal and a capacitive voltage sensor arrangement according to the present disclosure. Thereby, the first sensor output terminal is connected to the first measurement output terminal and the second sensor output terminal is connected to the second measurement output terminal. The voltage sensor system further comprises a measurement device with a burden capacitance arranged between the first measurement output terminal and the second measurement output terminal and a burden resistance arranged in parallel to the burden capacitance.

Advantageously, the presented capacitive voltage sensor arrangement can be integrated into a system with a measurement device, which performs the actual voltage measurement. The measurement device is advantageously represented by a burden resistance and a burden capacitance. As will be described in detail below, the position of the tuning circuit within the sensor system can vary and can be flexibly adapted as it is required.

According to an advantageous further development of the present disclosure, the voltage sensor system comprises a signal cable having a signal cable capacitance arranged between the first measurement output terminal and the second measurement output terminal.

In this advantageous embodiment of the present disclosure, the tuning circuit is arranged closer to the capacitive voltage divider. The tuning circuit is preferably arranged either directly at the voltage sensor or arranged closer to the sensor at the beginning or in the middle of the signal cable that connects the voltage sensor and, in particular, the capacitive voltage divider to the measurement device.

According to an advantageous further development of the present disclosure, the voltage sensor system comprises a signal cable having a signal cable capacitance arranged between the first node and the third node.

In this advantageous embodiment of the present disclosure, the tuning circuit is arranged closer to the measurement device. The tuning circuit may also be arranged directly at the measurement device.

It is explicitly pointed out that the advantageous effects of the tuning circuit such as adjusting the signal characteristics to compensate the impedance that occurs due to the voltage measurement and to meet the accuracy requirements of such a voltage measurement can be met by a plurality of different positions of the tuning circuit within the sensor system. The same positive effects can be achieved when placing the tuning circuit directly at the capacitive voltage divider, being a part of a voltage sensor or somewhere in between the voltage divider and the measurement device. This shows the high flexibility of the present solution.

According to an advantageous further development of the present disclosure, the signal cable capacitance is in the range of 2 pF - 1600 pF. Alternatively, the value of the signal capacitance can be described as being in the range of 15 pF/m - 160 pF/m. Thereby, the preferred length of the signal cable is up to 10 m.

According to an advantageous further development of the present disclosure, the burden capacitance is in the range of 0 pF - 5000 pF and/or the burden resistance is in the range of 2 kΩ - 10 MΩ.

Of course, the values for the signal cable and the measurement device are just exemplarily and the exact values depend on the used cable and measurement device. As describe above, the exact components and values of the tuning circuit are adaptable depending on the used capacitive voltage divider and are of course also dependent on the used cable and measurement device in order to provide the best tuning results.

According to an advantageous further development of the present disclosure, the tuning circuit is adapted to compensate the impedance of the burden caused by the measurement device arranged at the first measurement output terminal and the second measurement output terminal.

Performing the voltage measurement with a measurement device influences the signal characteristics of the voltage signal such that small errors in the phase and amplitude of the measured signal compared to the ideal signal occur. The present disclosure and, in particular, the idea of providing the presented tuning circuit advantageously aims to compensate these influences. Advantageously, the tuning circuit compensates the effects that are caused by the measurement device such as impedance of the burden.

The capacitive voltage sensor arrangement as presented is preferably used in medium or high voltage distribution networks. The highest system voltage between conductors is exemplarily between 7.2 kV and 42 kV for the medium voltage networks and exemplarily between 52 kV and 145 kV for the high voltage networks. However, the present disclosure is not limited to applications with a particular voltage or voltage range. The term *"low voltage"* relates to a voltage, which is exemplarily below 1 kV.

To better understand the present disclosure, this is explained in greater detail using the example depicted in the following Figures. Identical parts are hereby provided with identical reference numbers and identical component names. Furthermore, some features or combinations of features from the various examples shown and described may also represent independent solutions, inventive solutions or solutions according to the disclosure. In the drawings:
- **Fig. 1**: shows a voltage sensor arrangement according to the present disclosure,
- **Fig. 2**: shows a tuning circuit according to a first embodiment of the present disclosure,
- **Fig. 3**: shows a further tuning circuit according to a second embodiment of the present disclosure,
- **Fig. 4**: shows a further tuning circuit according to a third embodiment of the present disclosure,
- **Fig. 5**: shows a voltage sensor system according to the present disclosure,
- **Fig. 6**: shows a voltage sensor system according to a further embodiment of the present disclosure,
- **Fig. 7**: shows a voltage sensor system according to the present disclosure.

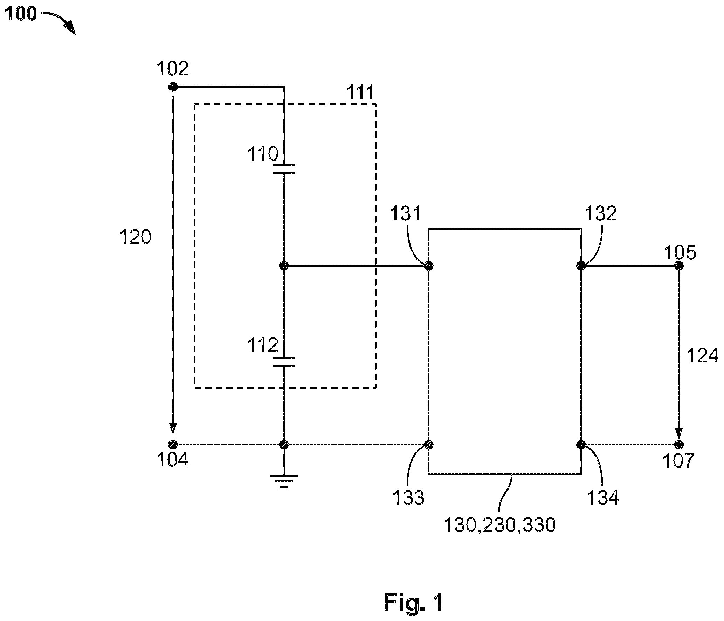

The present disclosure is explained with further details with reference to the Figures. **Fig. 1** shows a capacitive voltage sensor arrangement 100 according to the present disclosure. The capacitive voltage sensor arrangement 100 comprises a capacitive voltage divider 111 to transform a high voltage to a measurable medium or low voltage. Advantageously, the capacitive voltage divider 111 may also transform a medium voltage to a low voltage level. The capacitive voltage divider 111 is advantageously a part of a capacitive voltage sensor. A capacitive voltage divider 111 includes at least one primary capacitor 110 and at least one secondary capacitor 112 arranged in series and electrically connected to each other. The primary capacitor 110 is arranged between a first input terminal 102 and a first node 131 of the voltage sensor arrangement 100. The secondary capacitor 112 is arranged between the first node 131 and a second input terminal 104. The primary capacitor 110 is exemplarily chosen as the high voltage capacitor having a capacitance in the range of 10 - 20 pF. The secondary capacitor 112 is exemplarily chosen as the low voltage capacitor having a capacitance in the range of 41 - 82 nF.

Advantageously, the primary capacitor 110 and the secondary capacitor 112 are each formed of an electrode arrangement. In particular, each capacitor comprises two sensing electrodes. These sensing electrodes are preferably configured as disc-capacitors or are configured in form of coaxial electrode arrangements. Preferably, a conductive paste is applied on the disc-shaped material that forms the capacitor. The capacitors preferably consist of a conductive layer applied on a dielectric component such as ceramic, which provides a high accuracy and stability over a wide temperature range.

Between the first input terminal 102 and the second input terminal 104 the to-be-measured original high input voltage 120 is applied. The actual voltage that is measured is the voltage that is typically tapped from the node between the two capacitors and the second input terminal. This actually measured voltage is defined by the dividing factor of the voltage divider and gives a voltage representation of the high voltage that is applied between the two input terminals 102, 104 of the voltage sensor arrangement 100. Due to the technical realization of the capacitive divider and due to the connection to a measurement device, an error in the amplitude and the phase of the signal between the actual measured voltage and the original voltage occurs. That means that the measured signal is no perfect representation of the original high voltage and not only influenced by the dividing factor of the voltage divider, but contains a small deviation. Thus, the measured phase and amplitude of the signal deviates from the ideal phase and amplitude.

The maximum allowed magnitude of the error of the amplitude and the phase is defined in the international standard IEC 61869-1/6/11 (DIN EN 61869-6:2017-06; DIN EN 61869-1:2010-04; DIN EN 61869-11:2019-01). The standard includes the requirements, in particular, the error range for different values of different parameters, such as the magnitude of the voltage, the frequency and the temperature. For example, for different voltage levels and frequency ranges different maximum values are defined. Exemplarily, in an accuracy class of 0.5 the allowed amplitude error for the nominal frequency of 50 Hz and for a voltage amplitude in the range of 0.8 to 1.2 times the rated voltage at the primary capacitor of the capacitive voltage divider is 0.5 % and the allowed phase error is 0.33 degrees. Other frequency ranges and/or accuracy classes may have different error rates.

To tackle with the high accuracy requirements, the voltage sensor arrangement 100 of the present disclosure further comprises a tuning circuit 130, 230, 330. Different embodiments of the tuning circuit 130, 230, 330 can be realized and will be explained exemplarily below.

The tuning circuit 130, 230, 330 according to the present disclosure is arranged between the first node 131, a second node 132, a third node 133 and a fourth node 134.

The second node 132 is connected with a first sensor output terminal 105 of the voltage sensor arrangement 100. The fourth node 134 is connected with a second sensor output terminal 107 of the voltage sensor arrangement 100. Between the two sensor output terminals 105, 107, a sensor output voltage 124 can be tapped, which is defined by the applied original voltage at the inputs 102, 104 of the sensor arrangement, the dividing factor and the tuning factor of the tuning circuit 130, 230, 330.

Further, the third node 133 is connected with the second input terminal 104. The second input terminal 104 is exemplarily connected to ground.

The sensor arrangement 100 of the present disclosure comprises the capacitive voltage divider 111 and the tuning circuit 130, 230, 330. The capacitive voltage divider can be in the form of a capacitive voltage sensor having one of the commonly known shapes of these sensors. Commonly used realizations of such sensors are post-insulators, bushings or switchgear connectors. Preferably, the sensors are realized as plugs that are to be used with switchgear connectors. Thereby, the tuning circuit 130, 230, 330 can be included into the capacitive voltage sensor or be a separate part. Thus, the capacitive voltage sensor arrangement 100 may comprise a capacitive voltage sensor and the tuning circuit 130, 230, 330, whereby the capacitive voltage sensor comprises the capacitive voltage divider 111. In another embodiment, the capacitive voltage sensor arrangement 100 may comprise a capacitive voltage sensor, which includes both, the capacitive voltage divider 111 and the tuning circuit 130, 230, 330.

The tuning circuit 130, 230, 330 according to the present disclosure comprises only one or more passive components. This means that the tuning circuit 130, 230, 330 according to the present disclosure enables to meet the accuracy requirements for the measured voltage with respect to the amplitude and phase error without requiring to provide active components. Thus, in the tuning circuit 130, 230, 330 advantageously no active components are present. This simplifies the design and complexity of the tuning circuit, while still enables to meet the accuracy requirements.

The term *"passive components"* hereby relates to components, which have no function of gain, or control over voltage or current. Therefore, the controlling function of a passive component is linear. Speaking differently, passive components have no amplifying effect and no control function. Further, passive components can have linear or non-linear electrical properties. Examples for passive components are resistors, capacitors, inductors or memristors. In contrast thereto, *"active components"* have a function of gain or control such that the controlling of the parameters is not linear. Active components enable a circuit to output an electrical signal in some form with higher power than what is provided by the source of the signal. Further, active components allow a type of control meaning that auxiliary energy is drawn from an additional supply or they generate energy themselves. Examples for active components are transistors or amplifiers.

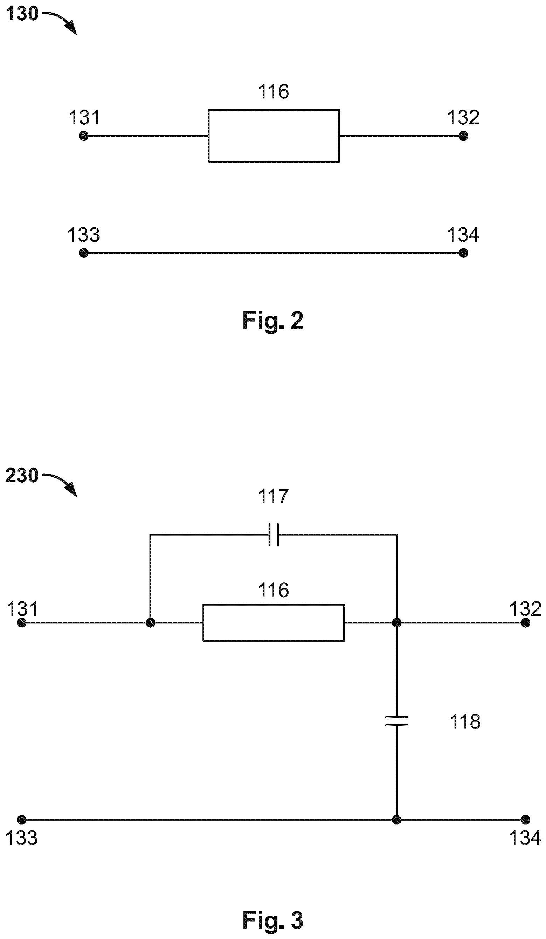

Advantageous examples of the tuning circuit 130, 230, 330 according to the present disclosure are shown in Fig. 2 to 3. Simply speaking, the tuning circuit is adapted to adjust the signal characteristics in the system to deal with the burden that occurs due to the technical realization of using a measurement device.

A first embodiment of the tuning circuit according to the present disclosure is shown in **Fig. 2****.** The tuning circuit 130 according to this embodiment comprises at least one first resistor 116 that is arranged between the first node 131 and the second node 132. Further, the third node 133 is connected with the fourth node 134. Including the resistor 116 influences the dividing factor of the primary and the secondary capacitors 110, 112 of the capacitive voltage divider. This positively influences the phase and amplitude of the signal, such that the deviation between the actual measured signal and the ideal measured signal meets the requirements of the international standard for a wide range of frequencies. In particular, the described tuning circuit 130 reduces the phase and amplitude error of the measured signal. In detail, including the resistor 116 reduces the phase error but may introduce a voltage drop over the resistor 116. This voltage drop can advantageously be compensated by adjusting the divider ratio of the primary and secondary capacitors 110, 112 such that an intended output signal at the sensor output terminals 105, 107 can be achieved.

A second embodiment of the tuning circuit according to the present disclosure is shown in **Fig. 3****.** The tuning circuit 230 according to this embodiment comprises the first resistor 116 arranged between the first node 131 and the second node 132. Further, the tuning circuit 230 comprises at least one capacitor. Exemplarily, the tuning circuit 230 comprises a first capacitor 117 arranged in parallel to the first resistor 116 between the first node 131 and the second node 132. Further, a second capacitor 118 is exemplarily arranged between the second node 132 and the third node 133. The second capacitor 118 can advantageously also denote the input capacitance of a measurement device that is connected to the tuning circuit (see description below) and that has a preferred value of around 50 pF. The third node 133 is connected to the fourth node 134.

This further advantageous example of the tuning circuit 230 allows for meeting the requirements of the phase and amplitude error as defined in the international standard for a large frequency range. In particular, the requirements on the accuracy for high frequencies can be met. Exemplarily, the accuracy for frequencies in the range of 1 Hz - 650 Hz can be met.

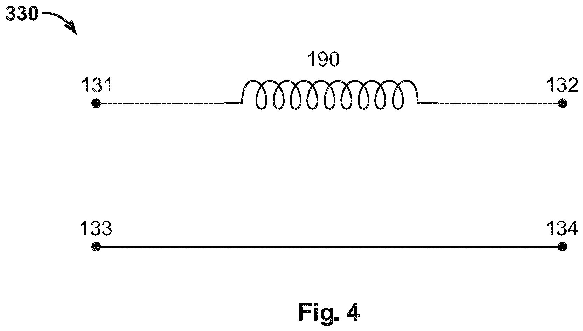

A third embodiment of the tuning circuit 330 is shown in **Fig. 4****.** In this embodiment, the tuning circuit 330 comprises an inductor 119 arranged between the first node 131 and the second node 132. Further, the third node 133 is connected to the fourth node 134. This embodiment shows that beside of using resistors and capacitors, also inductors can be used to influence the impedance of the system. The inductance of the inductor is preferably in the range of 4 Henry [H]. In a further preferred embodiment (not shown), the inductor 119 is arranged in series with a resistor between the first node 131 and the second node 132. Such an arrangement has the further advantageous effect that potentially occurring oscillations can be avoided or reduced.

It is clear that also modifications and different arrangements of the presented components within the tuning circuit are feasible and within the scope of the present disclosure. The exact arrangement of resistors, capacitors and/or inductors may be varied depending on the specific requirements on the phase and amplitude error. Further, it is clear that the exact arrangement and design of the components of the tuning circuit also depends on the voltage level, via which the sensor arrangement is operated and on which also the choice of the primary and secondary capacitors 110, 112 depends. Speaking differently, the design and arrangement of the components of the tuning circuit may be influenced by the to-be-achieved voltage level of the voltages at the primary and secondary capacitors 110, 112. This to-be-achieved voltage level is advantageously defined by the intended dividing ratio of the capacitive voltage divider. Further, also the choice of the measurement device influences the occurring phase and amplitude error, which then affects the design of the capacitive voltage divider and the tuning circuit.

When a capacitive voltage sensor arrangement 100 as described above is used to transform and measure the voltage in the system, the first and second sensor output terminals 105, 107 are connected to the measurement device, where the actual measured signal is obtained. As already indicated above, the connection and thus the realization of the capacitive voltage divider causes a deviation between the original high voltage signal and the actual measured signal, which is referred to as error of the measured signal.

In particular, the connection with the measurement device can be understood as a finite resistance value that is applied at the output of the capacitive voltage divider. This finite resistance causes a phase shift of the signal, which then causes phase error between the original and the measured voltage signal. Amplitude error is primarily influenced by parameters such as the tolerances of the components.

With the capacitive voltage sensor arrangement having the tuning circuit as presented, an easily realizable and cost efficient solution to compensate the error that is caused by the technical realization of the system is provided. With this solution the high requirements on the accuracy of the voltage measurement can be met.

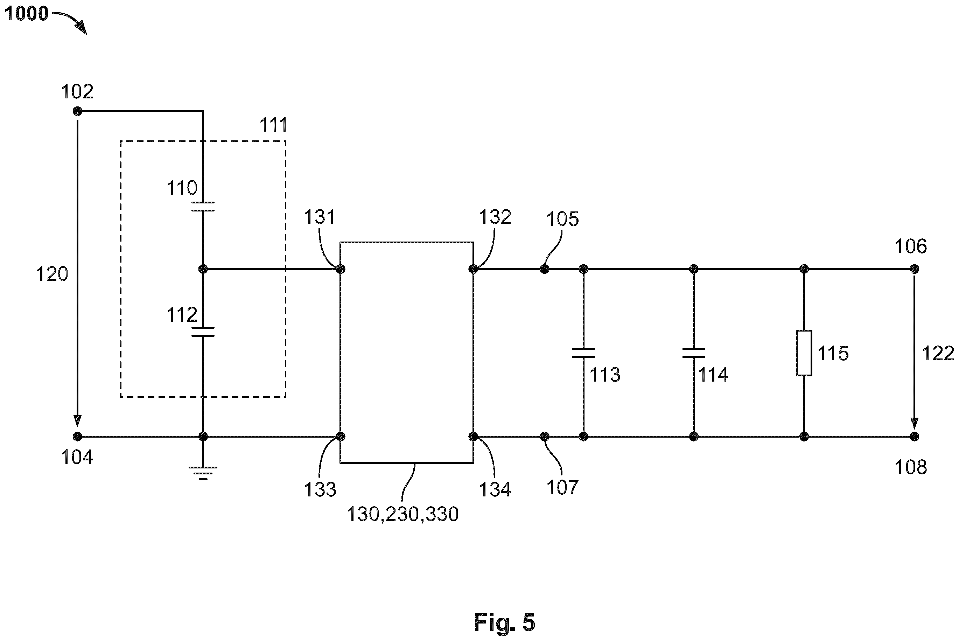

**Fig. 5** shows the described voltage sensor arrangement included into a system with the measurement device, an intelligent electronic device (IED). In the shown system 1000, the first sensor output terminal 105 is connected to a first measurement output terminal 106. The second sensor output terminal 107 is connected to the second measurement output terminal 108. The measurement output terminals 106, 108 and, in particular, the voltage tapped from these terminals represents the technical realization of the output voltage of the voltage sensor arrangement and depicts the actual voltage that is measured.

Exemplarily, the sensor output terminals are connected to the measurement device via a signal cable. The length of the signal cable, as well as its exact position in the system, may vary depending on the realization of the sensor system. Exemplarily, the signal cable is depicted as comprising a cable capacitance 113 and is exemplarily arranged between the first measurement output terminal 106 and the second measurement output terminal 108.

The value of the signal cable's capacitance depends on the parameters of the cables, but is exemplarily described as being between [100 - 500] pF.

Further, the properties of the measurement device are depicted as resistance and capacitance. The burden resistance 115 of the measurement device is arranged in parallel to the cable capacitance 113 between the first measurement output terminal 106 and the second measurement output terminal 108. The burden capacitance 114 of the measurement device is again arranged in parallel to the signal cable capacitance 113 and also in parallel to the burden resistance 115.

Depending on the values of the burden, the type of measurement device, the influence on the signal varies. Values for the burden are defined in an international standard. The standard IEC 61869-1/6/11 (DIN EN 61869-6:2017-06; DIN EN 61869-1:2010-04; DIN EN 61869-11:2019-01) defines the standard for the burden in such a system to be between 2 kΩ - 2.1 MΩ and [0 - 5000] pF, in particular 2 MΩ and 50 pF. However, the exact values for lEDs in the market may deviate from the defined values.

As indicated above, when measuring the transformed signal, a phase and amplitude error between the original voltage and the transformed, measured voltage occurs. To solve this problem, the present disclosure focuses on a voltage sensor arrangement, which includes a tuning circuit that corrects the occurring error such that the accuracy requirements as defined in the above-mentioned international standard can be met. The tuning circuit 130,230,330 aims to compensate the impedance of the burden caused by the measurement device arranged at the first measurement output terminal and the second measurement output terminal.

As mentioned above, it is also within the present disclosure, that the tuning circuit is not provided directly at the sensor arrangement but may also be provided at the beginning or at the end of a cable that connects the sensor arrangement with the measurement device. Alternatively, the tuning circuit can be provided within the measurement device. In particular, the described advantageous effects can be achieved with a tuning circuit being arranged at some position between the original voltage applied at the capacitive voltage divider and the measured voltage at the measurement device. The exact position of the tuning circuit can be chosen depending the exact application and the requirements in the field.

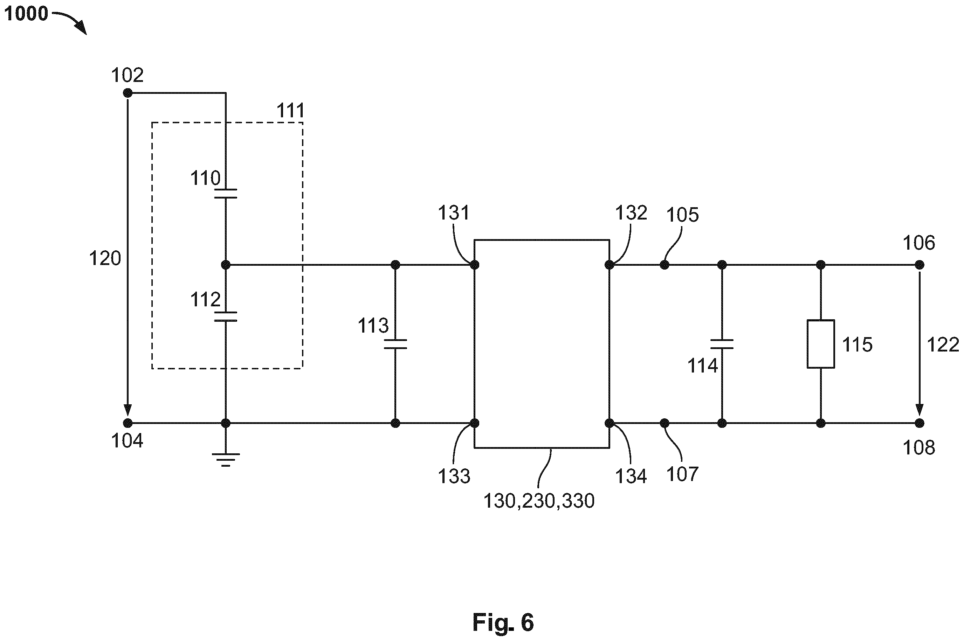

A system having the tuning circuit arranged closer to the measurement device is exemplarily shown in Fig. 6 of the present disclosure. It shows the flexibility and adaptability of the presented solution and, in particular, of the exact arrangement of the tuning circuit. Depending on the application and the installation in the field, the tuning circuit can be positioned where requirements such as space or safety allow it to be installed and still provides an easy and effective solution to correct the occurring phase and amplitude error.

As shown in Fig. 6, the voltage sensor system 1000 comprises the capacitive voltage sensor arrangement 100 having a capacitive voltage divider 111 as described above. Further, the tuning circuit 130, 230, 330 of the capacitive voltage sensor arrangement 100 is advantageously arranged closer to the measurement device. This is depicted by the signal cable capacitance 113 being arranged between the first node 131 and the third node 133 and the burden capacitance 114 and the burden resistance 115 being arranged between the second node 132 and the fourth node 134. Since, the second node 132 is connected with the first measurement output terminal 106 and the fourth node 134 is connected with the second measurement output terminal 108, the position of the burden capacitance 114 and the burden resistance 115 can also be described with respect to the output terminals 106, 108.

As shown in Fig. 5 and 6, the capacitive voltage sensor arrangement may comprise the signal cable or may not. This solely depends on the choice of the arrangement of the tuning circuit, but different options are within the scope of the present disclosure and as mentioned above lead to the advantageous effects.

With the presented solution, the accuracy requirements on the phase and amplitude error of a voltage measurement system can be met for lower values of the capacitance of the primary capacitor of a capacitive voltage divider. In particular, without the tuning circuit as presented a primary capacitor having a capacitance of above 40 pF was required for a transformation ratio of 6135.85/1 as defined in the international standard IEC 61869-1/6/11 (DIN EN 61869-6:2017-06; DIN EN 61869-1:2010-04; DIN EN 61869-11:2019-01).

With the presented solution of including a tuning circuit, the requirements of the standard for a transformation ratio of 6135.85/1 can be met for a primary capacitor having a capacitance of around 20 pF or even less. This shows that with the presented solution the required value of the capacitance that was necessary to meet the standard has been halved.

Since the value of the capacitance of a capacitor has a direct influence on the size of the capacitor, the size of the capacitor and therefore the size of the sensor arrangement can be drastically reduced with the solution as presented.

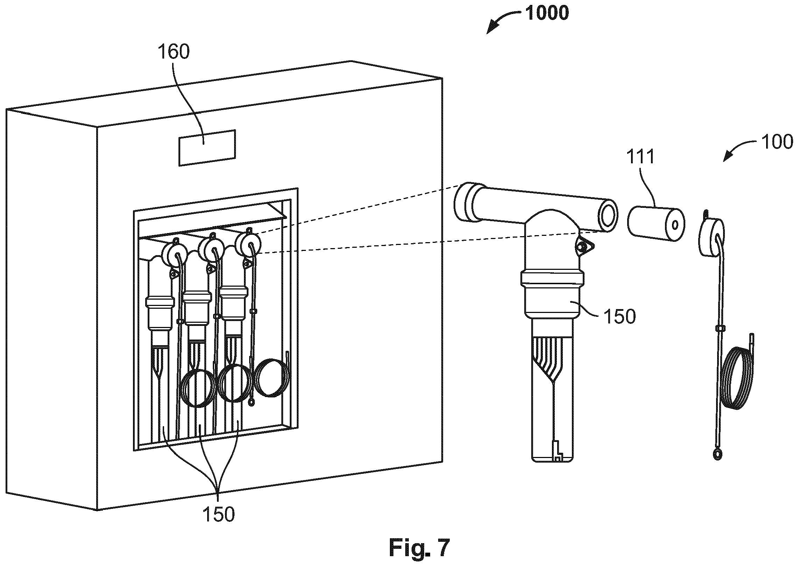

**Fig. 7** shows the voltage sensor system 1000 according to the present disclosure and its installation in the field. The capacitive voltage sensor arrangement 100 is exemplarily depicted in the form of a switchgear connector 150. Multiple switchgear connectors 150 are connected to an lED 160 in a switchgear, where the voltage measurement takes place. The lED 160 is preferable an electronic device installed on the front of the switchgear. Each switchgear connector 150 comprises the capacitor voltage sensor arrangement 100 with the capacitive voltage divider 111.

### List of reference signs

| **Reference Numeral** | **Description** |
|---|---|
| 100 | Capacitive voltage sensor arrangement |
| 102 | First input terminal |
| 104 | Second input terminal |
| 105 | First sensor output terminal |
| 106 | First measurement output terminal |
| 107 | Second sensor output terminal |
| 108 | Second measurement output terminal |
| 110 | Primary capacitor |
| 111 | Capacitive voltage divider |
| 112 | Secondary capacitor |
| 113 | Signal cable capacitance |
| 114 | Burden capacitance |
| 115 | Burden resistance |
| 116 | First resistor |
| 117 | First capacitor |
| 118 | Second capacitor |
| 119 | Inductor |
| 120 | Sensor input voltage |
| 122 | Measurement output voltage |
| 124 | Sensor output voltage |
| 130,230,330 | Tuning Circuit |
| 131 | First node |
| 132 | Second node |
| 133 | Third node |
| 134 | Fourth node |
| 150 | Switchgear connector |
| 160 | lED |
| 1000 | Voltage sensor system |

## Claims

1. Capacitive voltage sensor arrangement (100) for an electric energy distribution network, the capacitive voltage sensor arrangement (100) comprising:
a first input terminal (102), a second input terminal (104), a first sensor output terminal (105) and a second sensor output terminal (107);
a capacitive voltage divider (111), the capacitive voltage divider (111) comprising:
a primary capacitor (110) arranged between the first input terminal (102) and a first node (131), and
a secondary capacitor (112) arranged between the first node (131) and the second input terminal (104) and electrically connected in series to the primary capacitor (110);
the voltage sensor arrangement (100) further comprising:
a tuning circuit (130,230,330) arranged between the first node (131), a second node (132),
a third node (133), and a fourth node (134);
wherein the second node (132) is connected with the first sensor output terminal (105), the third node (133) is connected with the second input terminal (104), and the fourth node (134) is connected with the second sensor output terminal (107);
wherein the tuning circuit (130,230,330) comprises only one or more passive components.

2. Capacitive voltage sensor arrangement (100) according claim 1, wherein
the tuning circuit (130,230) comprises a first resistor (116) arranged between the first node (131) and the second node (132), and wherein the third node (133) of the tuning circuit (130) is directly connected with the fourth node (134).

3. Capacitive voltage sensor arrangement (100) according to claim 2, wherein the tuning circuit (230) further comprises:
a first capacitor (117) arranged in parallel to the first resistor (116) between the first node (131) and the second node (132); and
a second capacitor (118) arranged between the second node (132) and the third node (133).

4. Capacitive voltage sensor arrangement (100) according to claim 1, wherein
the tuning circuit (330) comprises an inductor (119) arranged between the first node (131) and the second node (132), and wherein the third node (133) of the tuning circuit (130) is directly connected with the fourth node (134).

5. Capacitive voltage sensor arrangement (100) according to one of the preceding claims,
wherein the primary capacitor (110) is formed by an electrode arrangement and a dielectric material or is formed by at least one discrete capacitor; and/or wherein
the secondary capacitor (112) is formed by an electrode arrangement and a dielectric material or is formed by at least one discrete capacitor.

6. Capacitive voltage sensor arrangement (100) according to one of the preceding claims,
wherein
the primary capacitor (110) comprises a capacitance of 10 pF - 30 pF and/or wherein the secondary capacitor (112) comprises a capacitance of 30 nF - 300 nF.

7. Capacitive voltage sensor arrangement (100) according to one of claims 2 or 3, wherein
the first resistor (116) comprises a resistance of 500 kΩ - 2 MΩ and/or wherein
the first capacitor (117) comprises a capacitance of 1 pF - 50 pF and/or wherein
the second capacitor (118) comprises a capacitance of 1 pF - 500 pF.

8. Capacitive voltage sensor arrangement (100) according to claim 4, wherein the inductor (119) comprises an inductance of 0.1 H - 5 H.

9. Capacitive voltage sensor arrangement (100) according to one of the preceding claims, wherein the second input terminal (104) is connected to ground.

10. Voltage sensor system (1000), the system (1000) comprising:
a first measurement output terminal (106) and a second measurement output terminal (108);
a capacitive voltage sensor arrangement (100) according to one of the preceding claims;
wherein the first sensor output terminal (105) is connected to the first measurement output terminal (106) and the second sensor output terminal (107) is connected to the second measurement output terminal (108); and
a measurement device comprising a burden capacitance (114) arranged between the first measurement output terminal (106) and the second measurement output terminal (108) and comprising a burden resistance (115) arranged in parallel to the burden capacitance (114).

11. Voltage sensor system (1000) according to claim 10, the system (1000) further comprising a signal cable comprising a signal cable capacitance (113) arranged between the first measurement output terminal (106) and the second measurement output terminal (108).

12. Voltage sensor system (1000) according to claim 10, the system (1000) further comprising a signal cable comprising a signal cable capacitance (113) arranged between the first node (131) and the third node (133).

13. Voltage sensor system (1000) according to one of claims 11 or 12, wherein
the signal cable capacitance (113) is in the range of 2 pF - 1600 pF.

14. Voltage sensor system (1000) according to one of claims 10 - 13, wherein
the burden capacitance (114) is in the range of 1 pF - 5000 pF and/or wherein
the burden resistance (115) is in the range of 2 kΩ - 10 MΩ.

15. Voltage sensor system (1000) according to one of claims 10 - 14, wherein the tuning circuit (130,230,330) is adapted to compensate the impedance of the burden caused by the measurement device arranged at the first measurement output terminal (106) and the second measurement output terminal (108).
